Europäisches Patentamt

European Patent Office

Office européen des brevets

(11) Publication number: 0 325 328
A1

## EUROPEAN PATENT APPLICATION

(21) Application number: 89200087.8

(51) Int. Cl.⁴: H01L 21/285 , H01L 21/263

(22) Date of filing: 16.01.89

The title of the invention has been amended (Guidelines for Examination in the EPO, A-III, 7.3).

(30) Priority: 20.01.88 GB 8801171

(43) Date of publication of application:
26.07.89 Bulletin 89/30

(84) Designated Contracting States:
DE FR GB IT NL

(71) Applicant: N.V. Philips' Gloeilampenfabrieken
Groenewoudseweg 1
NL-5621 BA Eindhoven(NL)

(72) Inventor: Bos-Cliteur, Aleida Antonetta
Philips Int. B.V. Corporate
Patents&Trademarks
Prof.Holstlaan 6 NL-5656 AA Eindhoven(NL)
Inventor: Jonkers, Alexander Gijsbertus
Mathias
Philips Int. B.V. Corporate
Patents&Trademarks
Prof.Holstlaan 6 NL-5656 AA Eindhoven(NL)
Inventor: Van Houtum, Hendrikus Josephus
Wilhelmus
Philips Int. B.V. Corporate
Patents&Trademarks
Prof.Holstlaan 6 NL-5656 AA Eindhoven(NL)
Inventor: Wolters, Robertus Adrianus Maria
Philips Int. B.V. Corporate
Patents&Trademarks
Prof.Holstlaan 6 NL-5656 AA Eindhoven(NL)

(74) Representative: Clark, Jane Anne et al
PHILIPS ELECTRONICS Patents and Trade
Marks Department Centre Point New Oxford
Street
London WC1A 1QJ(GB)

(54) A method of manufacturing a semiconductor device using sputter etching.

(57) A method of manufacturing a semiconductor device is described in which a substrate (1) is provided having doped semiconductor regions (3 to 13) for forming at least one (two in the example shown) electrical component, at least two of the doped silicon regions having respective exposed surface areas which are doped with different dopants, (for example surface areas 10a, 11a and 6a or surface areas 8a, 9a and 7a) and metal is deposited for forming a metal silicide (15a) at each of the said exposed surface areas (7a to 11a). Prior to deposition of the metal (15) to form the metal silicide (15a), the exposed silicon surface areas are subjected to an in-situ sputter etch, which facilitates formation of the metal silicide (15a).

FIG.5

Xerox Copy Centre

# A METHOD OF MANUFACTURING A SEMICONDUCTOR DEVICE

This invention relates to a method of manufacturing a semiconductor device, which method comprises providing a substrate having doped semiconductor regions for forming at least one electrical component, at least one of the doped silicon regions having an exposed surface area, and depositing metal for forming a metal silicide at each of the said exposed surface areas.

Such a method is described in EP-A-203836. In particular, EP-A-203836 describes a method of manufacturing a semiconductor device in the form of an integrated circuit having n-channel and p-channel insulated gate field effect transistors (MOSTs) and an npn lateral bipolar transistor. The n-channel MOST and npn lateral bipolar transistor are formed in p-type wells provided in an n-type monocrystalline silicon semiconductor body which forms the substrate and the various transistors are separated by field oxide formed by local oxidation of the silicon surface of the substrate.

Source and drain regions of the MOSTs are formed by implantation of impurities using previously defined doped polycrystalline silicon insulated gates and the field oxide as masks so that the source and drain regions are self-aligned to the insulated gates. Oxide spacers are formed on side walls of the insulated gates by anisotropic etching of a deposited oxide layer to expose the silicon surface areas of the source, drain and insulated gate regions. A metal layer capable of forming a metal silicide is deposited on the substrate surface so as, after an annealing step, to form a metal silicide on the exposed silicon surface areas. Metal remaining on oxide regions is then removed leaving the metal silicide on the exposed silicon surface areas.

The provision of such metal silicides on exposed silicon surface areas is advantageous in that it enables lower sheet resistances and contact resistances to be obtained. However, there are problems with the method described above. In particular, the formation of the metal silicide can be affected by the doping of the exposed silicon surface areas especially where that dose is relatively high so that the quality of the metal silicide layer depends on the type of silicon on which it is being formed. A paper entitled "Effects of ion implantation doping on the formation of titanium silicide" by H.K. Park et al published in J. Vac Sci Technol A2-(2) April-June 1984, at pages 264 to 268, illustrates this problem in connection with the formation of titanium silicide. In particular the authors of the paper state that they have found that implantation conditions in particular dopant concentration and distribution strongly affect the formation of titanium silicide, especially in the case of arsenic and phosphorus, the two n-type dopants commonly used in the formation of doped silicon regions.

According to one aspect of the present invention, there is provided a method of manufacturing a semiconductor device, which method comprises providing a substrate having doped semiconductor regions for forming at least one electrical component, at least one of the doped silicon regions having an exposed surface area, and depositing metal for forming a metal silicide at the exposed surface area, characterised by sputter etching the exposed surface area prior to depositing the metal to form the metal silicide.

The Inventors have found that in using a method embodying the invention the sputter etching enables oxide to be removed which would, despite conventional chemical wet etching to remove native oxide during previous processing steps, form on the exposed silicon surface area and that removal of this oxide facilitates formation of the subsequent silicide.

According to a second aspect of the present invention there is provided a method of manufacturing a semiconductor device, which method comprises providing a substrate having doped semiconductor regions for forming at least one electrical component, at least two of the doped silicon regions having respective exposed surface areas which are formed of different types of silicon and depositing metal for forming a metal silicide at each of the said exposed surface areas, characterised by sputter etching the exposed surface areas prior to depositing the metal to form the metal silicide.

The different types of silicon may be different in their physical properties and/or in their doping. Thus, for example, one of the two regions may be formed of monocrystalline silicon whilst the other is formed of polycrystalline (or amorphous) silicon and/or one of the two regions may be doped with a different (although not necessarily of the opposite conductivity type) dopant from the other exposed surface area.

The Inventors have found that by sputter etching the exposed surface areas prior to depositing the metal to form the metal silicide a more uniform formation of silicide can be obtained and that at least the initial rate or degree of silicide formation is considerably less dependent, if at all, on the type of silicon with which the silicide is being formed.

As mentioned above, the sputter etching serves to remove oxide which, despite conventional wet chemical etching to remove native oxide formed during previous processing steps, forms on the exposed silicon surface areas. The Inventors have also found that the sputter etching also forms a layer of amorphous silicon at each exposed silicon surface area. Thus not only does a method embodying the invention remove oxide which can be detrimental to silicide formation, but a method embodying the invention also provides silicon having the same or at least a similar physical structure at each exposed surface area. Therefore, the formation of silicide is less influenced by the physical structure, that is whether the exposed silicon surface area is polycrystalline amorphous or monocrystalline silicon. Also, the formation of the silicide is not affected by the ability of the exposed silicon surface area to form oxide. This latter feature is particularly important where the dopant used is phosphorus because phosphorus doped silicon, especially phosphorus doped polycrystalline silicon, is particularly prone to the formation of oxide because of the hydrophyllic nature of the phosphorus doped silicon.

Ions of an inert gas, preferably Argon, with an anergy in the region of from 30ev to 200ev are preferably used to sputter etch the exposed surface areas.

The metal used to form the silicide may be selected from the group consisting of platinum, cobalt and titanium. However, preferably the metal used for forming the silicide is titanium because titanium has been found to have the lowest sheet resistance of the suitable known silicides and is therefore particularly suitable for use in submicron technology integration where the reduced dimensions, especially junction depths and gate line widths required lead to high sheet and contact resistances unless a low resistivity material such as silicide, can be provided on top of exposed silicon areas. The use of a method in accordance with the invention may be particularly advantageous where titanium silicide is required. Thus, because of the high rate of diffusion of silicon in titanium it is possible during formation of titanium silicide that lateral diffusion of silicon from the exposed silicon surface areas into the titanium may be sufficient to form titanium silicide strips across oxide regions on the substrate surface, potentially providing undesired shorts between silicon regions. In order to avoid this, the silicide formation is carried out in a nitrogen-containing ambient atmosphere for example, an Argon/nitrogen atmosphere, an NH₃ atmosphere or any other suitable atmosphere from which nitrogen can diffuse into the titanium. Nitrogen from the ambient diffuses into the titanium layer and where the silicon and titanium diffusion fronts meet silicide formation is delayed. Thus because of the larger diffusion distance involved with lateral diffusion, titanium nitride rather than titanium silicide is formed on oxide regions and can later be selectively removed avoiding or at least reducing the problem of shorts. Although the use of a nitrogen ambient may overcome or at least mitigate the danger of undesired shorts, it may also exacerbate the problem of different rates of formation of titanium silicide on differently doped silicon areas because, for example, on an exposed surface area which is doped with phosphorus (such as a doped polycrystalline insulated gate of a MOST), silicide formation may be so slow that the nitrogen diffuses a very long way into the titanium resulting in a titanium silicide layer which is extremely thin, if present at all, on the phosphorus doped exposed silicon surface area and so in high sheet resistances. However, by using a method embodying the invention this problem can be overcome or at least mitigated since the rate of formation of titanium silicide will be similar if not identical on each region. Inded experiments have shown that titanium silicide layers of equal thickness can be formed at the same time on phosphorus doped polycrystalline silicon and on boron and arsenic doped monocrystalline silicon regions.

Embodiments of the invention will now be described, by way of example, with reference to the accompanying drawings, in which:

Figure 1 is a schematic cross-sectional view of part of a semiconductor body in which complementary insulated gate field effect transistors are being formed using a method in accordance with the invention; and

Figures 2 to 5 are each schematic cross-sectional views, enlarged relative to Figure 1, of part of the semiconductor body shown in Figure 1 illustrating subsequent steps of a method embodying the invention.

It should of course be appreciated that the Figures are diagrammatic and are not drawn to scale. Thus, the relative dimensions and proportions (particularly as regards thickness) have been shown exaggerated or diminished in the interests of clarity and convenience in the drawings.

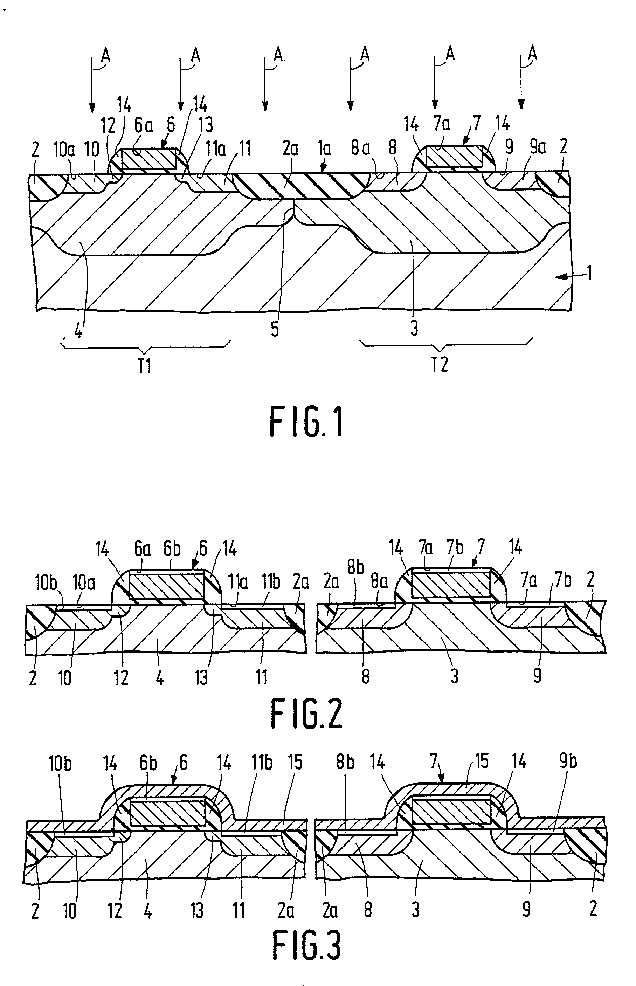

Referring now to the drawings, Figures 1 to 5 illustrate a method in accordance with the invention of manufacturing a semiconductor device. The method comprises providing a substrate 1 having doped semiconductor regions 3 to 13 for forming at least one (two in the example shown) electrical component, at least two of the doped silicon regions having respective exposed surface areas which are doped with different dopants, for example surface areas 10a, 11a and 6a or surface areas 8a, 9a and 7a in the example shown, and depositing metal 15 for forming a metal silicide 15a at each of the said exposed surface areas 7a to 11a. In accordance with the invention, the method comprises selectively forming a layer 6b, 7b, 8b, 9b, 10b and 11b of a given type of silicon at each of the said exposed surface areas 6a, 7a, 8a, 9a, 10a and 11a. prior to depositing the metal 15 to form the metal silicide 15a.

In the particular arrangement illustrated in the drawings, the substrate 1 comprises a semiconductor body, in this example a monocrystalline silicon body which is lowly doped so as to be of p-conductivity type. Complementary pairs of n-channel and p-channel insulated gate field effect transistors (IGFETS or MOSTs) are, as shown in Figure 1, being formed in the substrate 1 so as to provide a CMOS circuit such as a random access memory in which the various regions, metallisation, etc. may be of submicron dimensions.

Referring specifically now to Figure 1, there is shown part of the semiconductor body or substrate 1 on which one complementary pair of MOSTs consisting of an n-channel MOST T1 and a p-channel MOST T2 are being formed. It will of course be appreciated that many more such complementary pairs of MOSTs may be formed at the same time within the semiconductor body or substrate 1.

The structure or arrangement shown in Figure 1 may be formed using processing techniques which are conventional in the field of the manufacture of CMOS integrated circuit chips such as random access memories and therefore only a brief description of these processing steps will be given.

Thus, initially a silicon nitride mask is deposited and defined on a surface 1a of the semiconductor body 1 to enable formation of a field oxide pattern 1 by local oxidation of the silicon (LOCOS).

A photosensitive resist (hereinafter referred to as photoresist) is then applied to the surface 1a and patterned using conventional photolithographic and etching techniques to provide a mask for the implantation of n-type, in this example phosphorus, impurities to form an n well 3 for the p-channel MOST T2. After introduction of the n-type impurities and removal of the mask, further photoresist is applied to the surface 1a and patterned to define a mask for the implantation of p-type impurities, in this example boron, to form a p-type well 4 of the n-channel MOST T1.

Once the p-well mask has been removed, the oxidation step is performed as is known in the art with the silicon nitride mask still in place so as to form the field oxide 2 by local oxidation of the silicon (LOCOS) where the surface 1a is not protected by the silicon nitride mask. As can be seen from Figure 1, subsequent lateral diffusion of the impurities causes the n- and p-type wells 3 and 4 to meet at a pn junction 5 beneath a part 2a of the field oxide 2.

A relatively thin gate oxide layer is then provided on the surface 1a followed by a polycrystalline silicon layer. The gate oxide layer and polycrystalline silicon layer are patterned using conventional techniques to define insulated gates 6 and 7 for the MOSTs T1 and T2. As is known in the art, to provide the necessary electrical conductivity, the polycrystalline silicon is doped with impurities and, as is usual, phosphorus is used as it is better suited for this purpose than either arsenic or boron which are more likely to cause contamination of the gate oxide or even the underlying silicon. The plolycrystalline silicon may have a dopant concentration of about $8\times10^{20}$ atoms $cm^{-3}$.

After formation of the insulated gates 6 and 7, the area in which the MOST T1 is to be formed is masked and p-type impurities, boron in this example, introduced to form source and drain regions 8 and 9 of the p-channel MOST T2 with a dopant concentration of about $2\times10^{20}$ atoms $cm^{-3}$. The area of the MOST T2 is then masked and n-type impurities, phosphorus in this example, introduced to form relatively lowly doped extension regions 12 and 13 of source and drain regions 10 and 11 of the n-channel MOST T1 with a dopant concentration of about $5\times10^{18}$ atoms $cm^{-3}$.

Next, a blanket layer of silicon dioxide is deposited by chemical vapour deposition and then etched anisotropically to expose silicon surface areas 8a and 9a of the course and drain regions 8 and 9 and a silicon surface area 7a of the insulated gate of the p-channel MOST T2 and similarly to expose silicon surface areas 10a and 11a where the source and drain regions 10 and 11 of the n-channel MOST T1 are to be formed and to expose silicon surface area 6a of the insulated gate of the n-channel MOST T1. The anisotropic etching leaves oxide spacers 14 on side walls of the insulated gates 6 and 7.

With the area of the MOST T2 masked and after a scatter oxide deposition to protect the silicon surface 1a, impurities are introduced, using the insulated gate 6 and associated oxide spacers 14 as a mask, to form the source and drain regions 10 and 11 of the n-channel MOST T1 with a dopant concentration of about $8\times10^{20}$ atoms $cm^{-3}$.

In order to enable lower sheet and contact resistances and to provide low ohmic contacts for subsequent metallisation, a refractory metal silicide, in this example titanium silicide, is to be formed on the exposed silicon surface areas 6a, 7a, 8a, 9a, 10a and 11a.

Prior to depositing the metal to form the refractory metal silicide, native oxide remaining on the silicon surfaces 6a, 7a, 8a, 9a, 10a and 11a after the above processes have been completed is etched away using a wet chemical etching process, for example using a 1 Mol per cent solution of HF.

The semiconductor body or substrate 1 is then transferred to an rf (radio frequency) sputtering system for sputter deposition of a layer of titanium on the surface 1a. However, in accordance with the invention, prior to deposition of the metal, an in-situ sputter etch of the surface 1a with inert ions is carried out as indicated by the arrows A in Figure 1. The ions used for the sputter etch should be of an energy sufficient to enable sputter etching but not sufficient to cause significant implantation of the inert ions into the silicon surface areas 6a, 7a, 8a, 9a, 10a and 11a. Preferably, the sputtering is carried out using Argon ions with an energy lying in the range from about 30eV to 300eV although any other suitable inert ions, for example, Krypton, Xenon or Neon ions could be used. The rf sputtering system used should of course be capable of supporting the rf plasma to provide inert ions at the appropriate energies as mentioned above and a suitable machine is the Perkin Elmer 4400 rf sputtering system which has a counter-electrode of approximately the same or only slightly larger dimensions than the substrate holder to which the rf supply is connected, the counter-electrode being earthed.

The in-situ rf sputter etch described above serves, the Inventors have found, to remove oxide from the silicon surfaces 6a, 7a, 8a, 9a, 10a and 11a. In particular the in-situ rf sputter etch enables fresh oxide which may have formed on the exposed silicon surface areas 6a, 7a, 8a, 9a, 10a and 11a after the wet chemical etching step to be removed. This is especially important in the case of the phosphorus doped polycrystalline silicon exposed surface areas 6a and 7a as phosphorus doped polycrystalline silicon tends to be hydrophyllic (silicon is normally hydrophobic) and has a tendency to form nitric oxide causing fresh oxide growth after the wet chemical etching. The Inventors have also found that the above-described in-situ sputtering provides, as illustrated schematically in Figure 2, a respective layer 6b, 7b, 8b, 9b, 10b and 11b of amorphous silicon at each exposed surface area 6a, 7a, 8a, 9a, 10a and 11a without there being any significant degree of Argon ion implantation into the silicon.

To take a particular example, in the case of the Perkin-Elmer 4400 rf sputtering system, with an rf signal frequency of 13.5 MHz (Mega Hertz), a power of 500 W (Watts) providing a power density of 0.1 $Wcm^{-2}$ and with the substrate at room temperature (about 20 degrees Celsius) and an Argon pressure within the sputtering system of about 7 milliTorr ($0.93 \times 10^{-3}$Pa), the sputter etch may last in the region of 5 minutes and may remove from a monocrystalline silicon substrate a thickness of silicon dioxide of the order of 10 nm whilst providing of the order of from $1 \times 10^{16}$ to $2 \times 10^{16}$ atoms $cm^{-2}$ of amorphous silicon on the substrate with an argon contaminationn of the order of from $2 \times 10^{14}$ to $4 \times 10^{14}$ atoms $cm^{-2}$ to a depth within the monocrystalline silicon substrate of less than 20 nm, probably in the region of between 5 and 10 nm.

After the rf sputter etching the substrate 1 is maintained in the same rf sputtering system and a layer of refractory metal 15 is sputter deposited onto the surface 1a so as, as illustrated in Figure 3, to cover the exposed silicon surfaces 6a, 7a, 8a, 9a, 10a and 11a. In this particular example, the metal is titanium and where, as mentioned above, submicron dimensions are concerned, the sputter deposited layer 15 is of approximately 30 to 100 nanometres in thickness, although the thickness of the sputter deposited layer 15 will of course depend on the process dimensions, being typically in the region of 150 to 200 nm for a 1.5 micrometre process.

The sputter-deposited layer of titanium 15 is then annealed in a nitrogen atmosphere. In this example, the layer 15 is annealed using known rapid thermal processing, that is for 10 seconds at 650 degrees Celsius, in rapid thermal annealing system using tungsten halogen lamps as a radiant heat source although other annealing treatments could be used, for example a furnace heat treatment could be used.

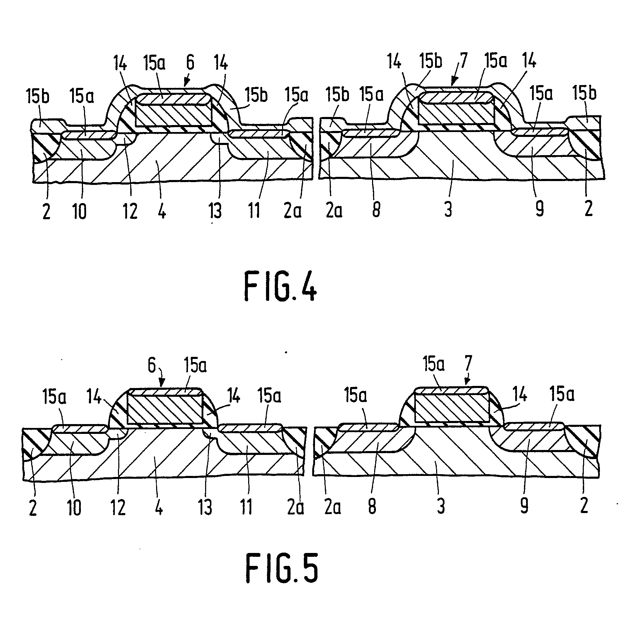

During the annealing, silicon diffuses from the exposed silicon surface areas 6a, 7a, 8a, 9a, 10a and 11a into the titanium layer 15 to form titanium silicide. Simultaneously, nitrogen from the surrounding nitrogen atmosphere diffuses into the titanium layer 15. Where the two diffusion fronts meet, the silicidation process is delayed. Accordingly as the lateral diffusion of silicon into the titanium covering the oxide regions, that is the field oxide 2 and the oxide spacers 14, takes a relatively long time because of the distance involved, the nitrogen will diffuse to a greater depth into the titanium layer over the oxide regions. Thus, as illustrated very schematically in Figure 4, over the exposed silicon surface areas 6a, 7a, 8a, 9a, 10a and 11a a layer of metal silicide 15a will be formed topped by a relatively thin layer of titanium nitride 15b whilst over the oxide regions 2, 14, in practice only a relatively thick layer of titanium nitride 15b is formed.

As illustrated by Figure 5, the layer of titanium nitride is then removed by a selective etching process, for example a wet chemical etch in a $NH_4OH/H_2O_2/H_2O$ solution which is very selective and does not attack the titanium silicide 15a and silicon dioxide of the oxide regions 2, 14. The exposed silicon surface areas 6a, 7a, 8a, 9a, 10a and 11a are now each covered, as illustrated in Figure 5, by a layer of metal silicide 15a and because of the oxide spacers 14 are electrically isolated. The silicide layer 15a is then subjected to a high temperature annealing step, for example the substrate is maintained in a nitrogen atmosphere and the temperature raised to 850 degrees Celsius for ten seconds, to convert the metastable C49 structure titanium silicide layer 15a to the stable and low ohmic C54 structure.

Where a titanium layer thickness of 40nm is sputter deposited, the Applicants have found that typically, using a method in accordance with the invention, a titanium silicide layer thickness of 50 to 70 nm is obtained leading to sheet resistances of 2.5 to 3.5 ohm/square. Moreover, the same thickness of titanium silicide is formed on both the monocrystalline and polycrystalline exposed silicon surface areas 6a, 7a, 8a, 9a, 10a and 11a. Thus, although it has been reported that titanium silicide formation does not, or only partly, takes place on heavily arsenic or phosphorus doped silicon areas (see for example the above-mentioned paper entitled "Effects of ion implantation doping on the formation of $TiSi_2$" by H.K. Park et al published in J. Vac. Sci. Technol. A2(2), April-June 1984, at pages 264 to 268), using a method in accordance with the invention no, or at least no significant, differences in rates of formation of titanium silicide were found when, in accordance with the invention, an in-situ sputter etch of the exposed silicon surface areas 6a, 7a, 8a, 9a, 10a and 11a is carried out before sputter depositon of the titanium.

The Inventors have thus found that the use of an in-situ sputter etch not only removes native oxide which may regrow on exposed silicon areas, especially heavily phosphorus doped polycrystalline silicon areas after wet chemical etching to remove native oxide, but also that the in-situ sputter etch provides an amorphous silicon surface layer 6b, 7b, 8b, 9b, 10b and 11b at each exposed surface area 6a, 7a, 8a, 9a, 10a and 11a so that the titanium is deposited onto the same given type of silicon at each exposed surface area 6a, 7a, 8a, 9a, 10a and 11a and thus the same, or practically the same, thickness of titanium silicide can be formed on the exposed surface areas regardless of the type of silicon, because the effects of the doping and of the physical structure (i.e. whether the material is polycrystalline, monocrystalline or amorphous) of the silicon regions on which the silicide is formed are considerably reduced. It is believed that this results because the removal of native oxide by the in-situ sputter etch means that the different rates or degrees of oxide formation by the different types of silicon surface area after wet chemical removal of native oxide are no longer relevant to rate or degree of formation of titanium silicide. Furthermore, the fact that the same type of silicon is present at each exposed silicon surface area 6a, 7a, 8a, 9a, 10a and 11a after the in-situ sputter etch means that the titanium reacts with a surface structure of the same physical structure, that is a given type of silicon, at each exposed surface area so that the silicide formation characteristics at least at the start of the silicidation process at each exposed silicon area are the same or similar.

In order to illustrate more clearly the effect of sputter etching exposed silicon surface areas in accordance with the invention prior to depositing the metal to form the metal silicide, experiments have been carried out to compare the sheet resistances (measured in ohms per sg, that is $\Omega/\square$) obtained for titanium silicide layers formed by depositing the titanium either 1) after a wet chemical etch, that is an HF dip or 2) after an in-situ sputter etch in the rf sputtering system in which the titanium is to be deposited. So as to ensure as uniform as possible conditions, the comparative experiments were carried out on monocrystalline silicon substrates which had not previously been subjected to other processing steps other than the introduction of a predetermined dopant, in these examples arsenic or phosphorus. In the case of arsenic, the doping was carried out by implanting ions at 50Kev (kilo electron volts) into the substrate through a 30 nm scatter oxide and using various different doses. In the case of phosphorus, the doping was carried out using a conventional $PH_3$ phosphorus doping process in a furnace so that the dopant concentration was determined by the solubility of the dopant in the substrate.

The results of the experiments show that although with a dose of up to about $2\times10^{15}$ atoms $cm^{-2}$ of arsenic ions, the sheet resistance Rs of a titanium silicide formed after the titanium had been deposited without a prior in-situ sputter etch was still acceptable with value of, for example 6.3 $\Omega/\square$ being measured for an arsenic ion dose of $2\times10^{15}$ atoms $cm^{-2}$, when the arsenic ion dose was further increased, the sheet resistance of the subsequently formed titanium silicide layer was unacceptably high with values of, for example, 31 $\Omega/\square$ for a dose of $3\times10^{15}$ atoms $cm^2$ and 41 $\Omega/\square$ for a dose of $5\times10^{15}$ atoms $cm^{-2}$ of arsenic ions. However, when similar experiments were carried out with the titanium being deposited after an in-situ sputter etch as described above, sheet resistances of, for example, 4.2 $\Omega/\square$ for an arsenic ion dose of $2\times10^{15}$ atoms $cm^{-2}$ and 7.3 $\Omega/\square$ for an arsenic dose of $5\times10^{15}$ atoms $cm^2$ were measured. Thus, after a sputter etch in accordance with the invention acceptable sheet resistances were still being obtained with arsenic doses as high as $5\times10^{15}$ atoms $cm^{-2}$ whereas when merely a conventional wet chemical etch was used unacceptably high sheet resistances were obtained at such doses. The results for phosphorus doping seem even more marked in that the formation of silicide was erratic and in some circumstances none was formed when only a conventional wet chemical etch was claimed art prior to deposition of the metal whereas when an in-situ sputter etch was carried out acceptable sheet resistances, for example of the order of $5.3\Omega/\square$, were measured.

Other experiments carried out by the Inventors have shown that whereas with a conventional wet chemical etch there are considerable differences in the ease and rate of formation of silicide on monocrystalline and polycrystalline silicon, especially in the formation of titanium silicide on phosphorus doped monocrystalline and polycrystalline silicon, after an in-situ sputter etch is carried out in accordance with the invention formation of silicide is facilitated and moreover the rates of formation do not vary significantly between the monocrystalline and polycrystalline silicon.

A method in accordance with the invention may be used where the refractory metal to be sputter-deposited is other than titanium and may be particularly applicable where, as described above with reference to the use of titanium, the silicon diffusion process during silicidation competes with another diffusion process (nitrogen in the example given above) to ensure that silicide does not form on oxide regions because in such circumstances, as explained above for the example of titanium silicide formation, it is especially important that silicidation at a particular surface is not hindered because of contamination and/or characteristics of the surface.

A method embodying the invention also is advantageous where the metal to be used to form the silicide cannot, or can only with difficulty, remove oxide from the silicon surface areas at which the silicide is to be formed. Thus, although after a conventional wet etching treatment the rates of formation of silicides such as platinum or cobalt silicide will vary significantly dependent on the amount of oxide contaminating the silicon surface, so providing particular problems as will be understood from the above for phosphorus doped monocrystalline and polycrystalline silicon. Using a method in accordance with the invention which results in the removal of such oxide, the formation of cobalt or platinum silicide, especially on phosphorus doped polycrystalline silicon, may be improved.

After formation of the metal silicide layer 15a, although not shown, further oxide is deposited and windows opened, as is conventional, to enable conductive material, for example aluminium, to be deposited to provide electrical connection to the source, gate and drains of the MOSTs and to interconnect the MOSTs as required.

It should of course be appreciated that a method in accordance with the invention may be applied to enable silicide formation to be improved even where only one type of doped silicon is present and may also be applied in other circumstances where a metal silicide is to be provided on differently doped silicon surfaces, for example where the electrical component is a bipolar transistor and silicide is required on the differently doped collector, base and emitter regions. Furthermore, although a method in accordance with the invention is particularly applicable to large scale and very large scale integration for example where submicron dimensions are involved, a method in accordance with the invention may also be used in other circumstances where silicide formation on differently doped silicon regions is required, for example in discrete or power semiconductor devices such as high frequency power MOS transistors.

It should also be understood that the conductivity types given in the example described above could be reversed (so that the substrate is n-type) and that a method in accordance with the invention may be applied where the semiconductor body comprises another semiconductor material, for example a III-V semiconductor material such as GaAs or where the semiconductor body is a composite of two, for example GaAs or silicon. Furthermore, a method embodying the invention could be applied where the substrate is other than a semiconductor body, for example in the field of liquid crystal display devices.

From reading the present disclosure, other modifications will be apparent to persons skilled in the art. Such modifications may involve other features which are already known in the art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation or modification of one or more of those features, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A method of manufacturing a semiconductor device, which method comprises providing a substrate having doped semiconductor regions for forming at least one electrical component, at least one of the doped silicon regions having an exposed surface areas, and depositing metal for forming a metal silicide at the exposed surface area characterised by sputter etching the exposed surface area prior to depositing the metal to form the metal silicide.

2. A method of manufacturing a semiconductor device, which method comprises providing a substrate having doped semiconductor regions for forming at least one electrical component, at least two of the doped silicon regions having respective exposed surface areas which are formed of different types of silicon, and depositing metal for forming a metal silicide at each of the exposed surface areas, characterised by sputter etching the exposed surface areas prior to depositing the metal to form the metal silicide.

3. A method according to Claim 2, which comprises providing the substrate so that the exposed surface areas of the two doped regions are doped with the same dopant.

4. A method according to Claim 2 or 3 which comprises providing the substrate so that the exposed surface areas of the two doped regions are doped with different dopants.

5. A method according to Claim 4, which comprises providing the substrate so that the exposed surface areas of the two doped regions are of opposite conductivity types.

6. A method according to claim 2, 3, 4 or 5, which comprises providing the substrate so that the exposed surface area of one of the two doped silicon regions is formed of monocrystalline silicon and the exposed surface area of the other of the two doped silicon regions is formed of polycrystalline silicon.

7. A method according to any one of Claims 2 to 6, wherein the step of providing the substrate having doped silicon regions comprises providing a monocrystalline silicon well of one conductivity type adjacent a given surface of the substrate, depositing a doped polycrystalline silicon region on an insulatinglayer on the said surface to define an insulated gate over the well, introducing impurities using the insulated gate as a mask to define source and drain regions of the opposite conductivity type within the well, providing an insulating layer on the said given surface and etching the insulating layer anisotropically so as to expose surface areas of the source and drain regions and of the polycrystalline silicon region of the insulated gate whilst leaving spacers of insulating material on side walls of the insulated gate.

8. A method according to any one of claims 2 to 6, wherein the step of providing the substrate having doped silicon regions comprises providing first and second monocrystalline silicon wells adjacent a given surface of the substrate, the first well being of one conductivity type and the second well of the opposite conductivity type, depositing a doped polycrystalline silicon region on an insulating layer on the said surface to define a respective insulated gate over each of the first and second wells, introducing impurities using the insulated gates as masks to define source and drain regions of the opposite conductivity type within the first well and source and drain regions of the one conductivity type within the second well, providing an insulating layer on the said given surface and etching the insulating layer anisotropically so as to expose surface areas of the source and drain regions and of the polycrystalline silicon regions of the insulated gates whilst leaving spacers of insulating material on side walls of the insulated gates.

9. A method according to Claim 6, 7 or 8, wherein the or each exposed surface polycrystalline silicon surface area is doped with phosphorus.

10. A method according to any one of the preceding claims, which comprises using ions of an inert gas with an energy in the region of from 30ev to 200ev (electron volts) to sputter etch the exposed surface area(s).

11. A method according to Claim 10, which comprises using argon ions as the inert gas ions.

12. A method according to any one of the preceding claims, which comprises depositing as the metal for forming the metal silicide a metal selected from the group consisting of platinum, cobalt and titanium.

13. A method according to Claim 12, which comprises depositing titanium as the metal for forming the metal silicide whilst maintaining the substrate in a nitrogen-containing atmosphere.

FIG.1

FIG.2

FIG.3

FIG.4

FIG.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | US-A-4 585 517 (STEMPLE) <br> * Whole document * | 1,2 | H 01 L 21/285 <br> H 01 L 21/263 |
| A | | 3,6,11 | |
| A,D | EP-A-0 203 836 (E.F.C.I.S.) <br> * Claim 1 * | 4-8 | |
| X | IEEE TRANSACTIONS ON ELECTRON DEVICES, vol. ED-34, no. 10, October 1987, pages 2108-2115, IEEE, New York, US; S.P. MURARKA et al.: "Self-aligned cobalt disilicide for gate and interconnection and contacts to shallow junctions" <br> * Page 2108 * | 1 | |
| A | IDEM | 12 | |
| A | THIN SOLID FILMS, vol. 153, no. 1, October 1987, pages 287-301, Elsevier Sequoia, Lausanne, CH; N. KUMAR et al.: "Growth and properties of Tin and TiOxNy diffusion barriers in silicon on sapphire integrated circuits" <br> * Page 289, lines 1-3 * | 13 | TECHNICAL FIELDS SEARCHED (Int. Cl.4) <br><br> H 01 L |
| A | IEEE TRANSACTIONS ON ELECTRON DEVICES, vol. ED-34, no. 3, March 1987, pages 682-688, New York, US; E. THOMAS et al.: "Titanium nitride local interconnect technology for VLSI" <br> * Page 682, column 2, lines 31-42 * | | |

The present search report has been drawn up for all claims

| Place of search | Date of completion of the search | Examiner |
|---|---|---|
| THE HAGUE | 07-03-1989 | PHEASANT N.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                              
& : member of the same patent family, corresponding document

EPO FORM 1503 03.82 (P0401)